# EUROPEAN PATENT APPLICATION

(11) **EP 1 906 447 A2**
(43) Date of publication of application: **02.04.2008**
(21) Application number: 07075813.1
(22) Date of filing: 18.09.2007
(51) Int. Cl.: H01L 23/473, H01L 23/427

(54) **Cooling of the power components of a frequency converter**

(30) Priority: 29.09.2006 FI 20060868
(71) Applicant: Vacon Oyj, 65380 Vaasa (FI)
(72) Inventor: Miettinen, Osmo, 65370 Vaasa (FI); Norrena, Juha, 65350 Vaasa (FI)
(74) Representative: Järveläinen, Pertti Tauno Juhani

(57) **Abstract**

Cooling arrangement for the power components (10) of a power transformer, in which is a cooler (12), which has a metal frame, to which the power components can be fitted, and cooling piping fitted inside the frame for removing thermal power from the power components by means of a flowing cooling medium, and a condenser (13) connected to the cooling piping, with which thermal power can be transferred out of the cooling piping. The cooler and the condenser have a shared metal frame (11), in which one part functions as the cooler part and the other part as the condenser part, and inside which is fitted the shared cooling piping of the cooler and the condenser for the flowing cooling medium.

## Description

### Field of technology

The object of this invention is a power transformer, such as a frequency converter, a cooling arrangement for power components, in which is a cooler, which has a metal frame, to which the power components can be fitted, and cooling piping fitted inside the frame for removing thermal power from the power components by means of a flowing cooling medium, and a condenser connected to the cooling piping, with which thermal power can be transferred out of the cooling piping.

### Prior art

In conventional frequency converters semiconductor power components, such as IGBTs, are fitted to a cooling plate, which transfers thermal power further e.g. by means of cooling piping and the cooling liquid flowing in it onwards to a condenser, in which the thermal power can be transferred from the cooling liquid into the air.

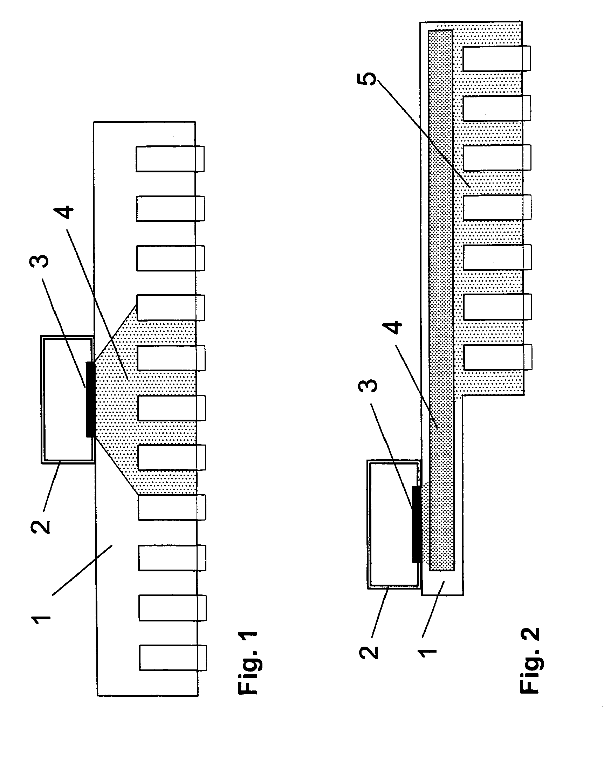

In air cooling solutions according to prior art the point-like dissipated power of a semiconductor component is dissipated only from the small area of the cooling plate close to the semiconductor component, in which case cooling is relatively inefficient (Fig. 1).

### Summary of the invention

The purpose of this invention is to achieve a new kind of cooling arrangement for the power components of a frequency converter.

According to the invention the cooler and the condenser have a shared metal frame, in which one half functions as a cooler and the other half as a condenser, and inside which is fitted the shared cooling piping of the cooler and the condenser for the flowing cooling medium.

The frame can be formed from one piece or otherwise from a plurality of frame pieces that are joined together.

The cooling medium piping can contain channels provided with a turbulator (a turbulator is e.g. an additional part resembling a spiral spring, which achieves rotation of the liquid flow, i.e. turbulence, in the channel which has an advantageous effect on heat transfer) for arranging enclosed liquid circulation between the ends. The cooling medium can be a cooling liquid, which is circulated with a pump. It can also be water under low pressure, which boils in the cooling part and liquefies in the condenser part (heating pipe), and in which the liquid/vapour circulation between the parts occurs without a pump. An array of fins can be connected to the condenser part for transferring thermal power into the air duct e.g. forced by a fan. A separate liquid element can also be connected to the condenser part for transferring thermal power to an external liquid circulation.

The frame of the cooling appliance can simultaneously function as the whole frame of the transformer appliance.

The characteristic features of the solution according to the invention are described in detail in the claims below.

By means of the invention a very compact and efficient cooling arrangement for the power components of a frequency converter can be achieved. More particularly by means of the invention point-like dissipation power dissipates utilizing all the cooling surface area, in which case cooling efficiency is significantly improved.

### Short description of the drawings

In the following, the invention will be described in more detail by the aid of an embodiment with reference to the attached drawings, wherein

Fig. 1 presents the transfer of dissipation power to a prior-art air cooler.

Fig. 2 presents the transfer of dissipation power to an air cooler according to the invention.

Fig. 3 presents a perspective drawing of the cooling appliance of a frequency converter according to the invention, and

Fig. 4 presents another cooling appliance of a frequency converter according to the invention.

### Detailed description of the invention

Fig. 1 presents how the dissipated power transfers to the cooler in a prior-art air cooler 1. Dissipated power is generated in the power semiconductor piece 3 contained in the power module 2, from where it transfers inside the cooler as is well known at a certain angle towards the cooling fins. Thus only a certain part of the array of fins of the cooler functions effectively (shaded part 4).

Fig. 2 presents the principle of the cooling solution according to the invention. In the figure a pipe 4 containing liquid is disposed in the shared metal frame 1 under the power module, which pipe transfers the dissipated power of the power semiconductor piece 3 to the condenser part 5, of which the whole cooling surface area is utilized since the liquid pipe extends to the whole finned area.

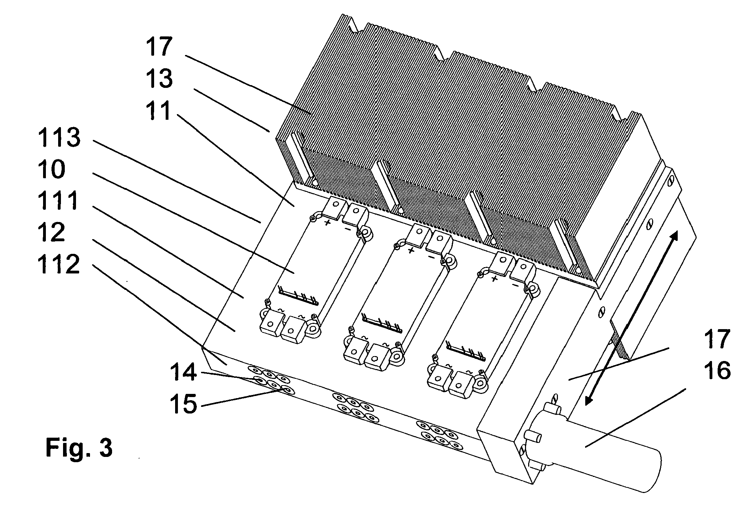

Fig. 3 presents a practical embodiment of a cooling appliance of a frequency converter according to the invention for cooling the power components 10 of the power stage, typically power semiconductor switches, e.g. IGBTs. In the appliance the frame part of the cooling solution is an integral right-angled metal part 11, in which are face surfaces 111, of which semiconductor switches are situated on one, end surfaces 112, and side surfaces 113, and in which one half functions as a cooler 12, with which the transfer of thermal power from the power components to the liquid is achieved, and the other half as a condenser 13, by means of which the transfer of thermal power from the liquid into the air is achieved (so-called primary cooling), and inside which are parallel and longitudinal (see the arrow between the cooler part and the condenser part) channels 15, provided with a turbulator 14, for arranging enclosed cooling liquid circulation between the ends, in which case a liquid circulation is achieved inside the cooler. In addition to the channels, an expansion tank can be disposed e.g. at the end of the condenser. The liquid can be water, which is circulated with a pump 16, which contains a frame part 17, which is connected at its side surface to the side of the metal frame 11 of the appliance.

The liquid can also be water under low pressure, which boils in the cooling part and liquefies by means of the heating pipes and the heating appliance in the condenser part, and in which the liquid/vapour circulation between the parts occurs without a pump. The liquid/vapour circulation can also be implemented in another manner suited to the purpose.

A metallic array of fins 17 is joined to one of the face surfaces or to both face surfaces (top and bottom surfaces) of the condenser part 13 for transferring dissipated power to the air duct under the force of the fan. Alternatively e.g. a separate liquid element can be connected to the condenser part for transferring thermal power to an external liquid circulation.

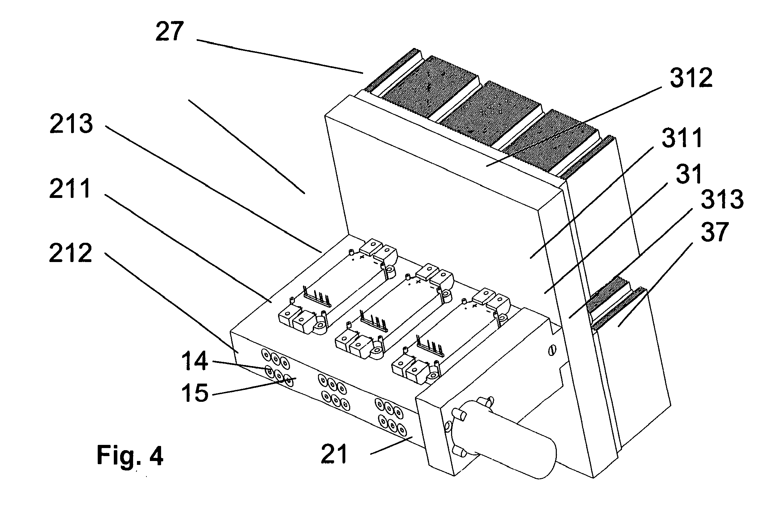

Fig. 4 presents another embodiment of a cooling appliance according to the invention, which has two right-angled frame parts 21 and 31, on which are face surfaces 211, 311, end surfaces 212, 312 and side surfaces 213, 313, and in which the frame parts are joined tightly together at the end surface 212 of one part and at the face surface 311 of the other part, and in both of which frame parts is cooling piping on the inside such that when joined together they form an integral cooling piping. IGBTs are arranged on the face surface of one frame part, which functions as a cooler, and a cooling array of fins to the other face surface of the other frame part, which can be comprised of two different fin array parts 27, 37, and which thus functions as a condenser.

It is obvious to the person skilled in the art that the different embodiments of the invention are not limited solely to the example described above, but that they may be varied within the scope of the claims presented below. Also other condenser solutions (so-called secondary cooling) can be used instead of a cooling array of fins. The solution according to the invention enables variation of the secondary cooling appliance, depending on the application and the usage site, at the latest possible stage, and no separate structures for secondary cooling are needed in the solution according to the invention.

## Claims

1. Cooling arrangement for the power components (10) of a power transformer, in which is a cooler (12), which has a metal frame, to which the power components can be fitted, and cooling piping fitted inside the frame for removing thermal power from the power components by means of a flowing cooling medium, and a condenser (13) connected to the cooling piping, with which thermal power can be transferred out of the cooling piping,
**characterized in that**
the cooler and the condenser have a shared metal frame (11, 21, 31), in which one part functions as the cooler part and the other part as the condenser part, and inside which is fitted the shared cooling piping of the cooler and the condenser for the flowing cooling medium.

2. Cooling arrangement according to claim 1,
**characterized in that** the cooling medium is liquid and the cooling medium piping contains channels for arranging enclosed liquid circulation.

3. Cooling arrangement according to claim 2,
**characterized in that** turbulators are arranged in the channels for improving heat transfer.

4. Cooling arrangement according to claim 1,
**characterized in that** the cooling medium is a liquid, which is circulated with a pump.

5. Cooling arrangement according to claim 1,
**characterized in that** the piping contains heating pipes and the cooling medium is water under low pressure, which can be made to boil in the cooling part and to liquefy in the condenser part.

6. Cooling arrangement according to any of the preceding claims,
**characterized in that** an array of fins is connected to the condenser part for transferring thermal power into the air duct e.g. forced by a fan.

7. Cooling arrangement according to any of claims 1 - 5,
**characterized in that** a separate liquid element is connected to the condenser part for transferring thermal power to an external liquid circulation.

8. Cooling arrangement according to any of the preceding claims,
**characterized in that** the frame of the cooling arrangement is simultaneously the whole frame of the transformer appliance or a part of it.

9. Cooling arrangement according to any of the preceding claims,
**characterized in that** the frame is formed from two or more connected frame parts, which are each joined to the facing surface of the other, and in which are cooling piping parts that are fitted to each other.

10. Cooling arrangement according to any of claims 1 - 8,
**characterized in that** the frame is formed from one frame piece.
